**Europäisches Patentamt**

(19) **European Patent Office**

**Office européen des brevets**

(11) Publication number : **0 448 135 B1**

(12) **EUROPEAN PATENT SPECIFICATION**

(45) Date of publication of patent specification :
08.11.95 Bulletin 95/45

(51) Int. Cl.⁶ : **H03K 19/003**

(21) Application number : **91108783.1**

(22) Date of filing : **23.06.87**

(54) **An output buffer circuit.**

(30) Priority : **30.06.86 US 880407**

(43) Date of publication of application :
**25.09.91 Bulletin 91/39**

(60) Publication number of the earlier application in
accordance with Art. 76 EPC : **0 251 880**

(45) Publication of the grant of the patent :
**08.11.95 Bulletin 95/45**

(84) Designated Contracting States :
**DE FR GB IT NL**

(56) References cited :
EP-A- 0 147 635
US-A- 4 339 676
US-A- 4 572 970

(73) Proprietor : **FAIRCHILD SEMICONDUCTOR
CORPORATION
2900 Semiconductor Drive
Santa Clara California 95052 (US)**

(72) Inventor : **Fraser, Dana
501 Westbrook Street Apt.110B
South Portland, Maine 04106 (US)**
Inventor : **Mentzer, Ray
399 Palmer Avenue
Portland, Maine 04103 (US)**
Inventor : **Gray, Jerry
3 Hunt Club Woods
Cape Elizabeth, Maine 04107-2006 (US)**
Inventor : **Hannington, Geoff
45 Briarwood Road
South Portland, Maine 04106 (US)**
Inventor : **Keown, Susan
32 Wolcott Street
Portland, Maine 04102 (US)**
Inventor : **Mathieu, Gaetan L.
609 Ocean Avenue Apt. 27
Portland, Maine 04104 (US)**

(74) Representative : **Sparing Röhl Henseler
Patentanwälte
Postfach 14 04 43
D-40074 Düsseldorf (DE)**

## Description

This invention relates to reducing the effect of transients on integrated circuit operation, and more particularly to reducing on-chip power rail perturbations and the effect of power rail perturbations on the operation of high speed digital integrated circuits.

Power rail perturbation is a transient condition found on the on-chip power distribution lines, most commonly $V_{cc}$ and ground, of certain types of high speed digital integrated circuits. The condition arises during the switching of high current or high power circuits of the integrated circuit, due to the interaction of parasitic inductances with localized power surges. One type of power rail perturbation, ground bounce, occurs when the potential of the internal ground of the device changes relative to system ground. A related condition involving internal $V_{cc}$ is known as $V_{cc}$ squeeze. Ground bounce along, $V_{cc}$ squeeze alone, or the combination of both cause spurious states and transitions to occur in the switched circuits as well as the other circuits coupled to the switched circuits, thereby corrupting retained data or causing spurious states or transitions to be transmitted in the output.

From document EP-A-0 147 635 an integrated circuit output buffer is known, comprising an input circuit, an output circuit having an output pulldown transistor, and a DC Miller killer circuit. The DC Miller killer circuit owns a first transistor for discharging charge coupled through the Miller capacitance of said output pulldown transistor, a second transistor for switching said first transistor in response to an output enable signal, and a discharge path between the base of said first transistor and ground for discharging stored charge from the base of said first transistor.

An object of the present invention is to reduce the effect of power rail perturbations on the performance of integrated output buffer circuits. The invention is defined by claim 1.

The integrated circuit output buffer as claimed owns an input circuit, an output circuit with an output pulldown transistor, and a DC Miller killer circuit. The DC Miller killer is improved to avoid aggrevating ground bounce. The improvements include delaying the turn-on of the DC Miller killer circuit, and limiting the discharge rate of the output pulldown transistor through the DC Miller killer circuit.

Figure 1       illustrates a latch circuit modified to reduce power rail perturbations (not claimed).

Figure 2       illustrates an embodiment of the invention, and

Figure 3       is a schematic illustration of a standard DC Miller killer circuit.

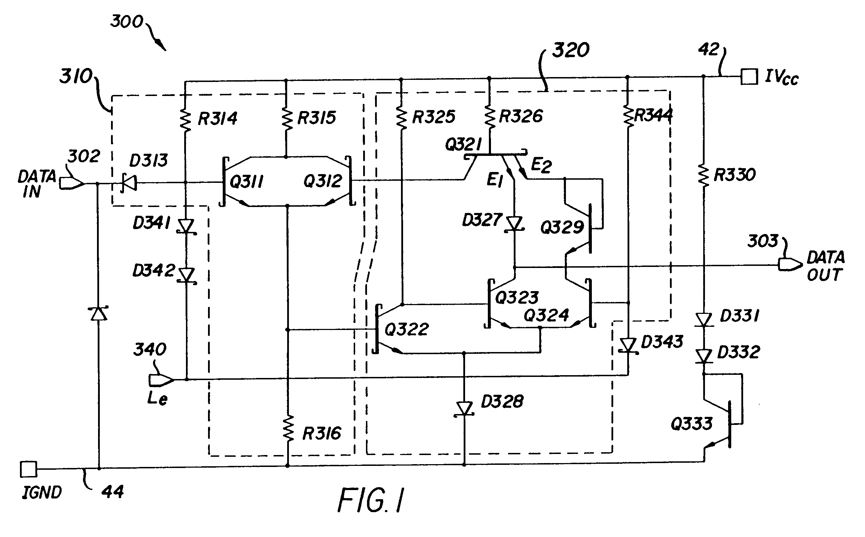

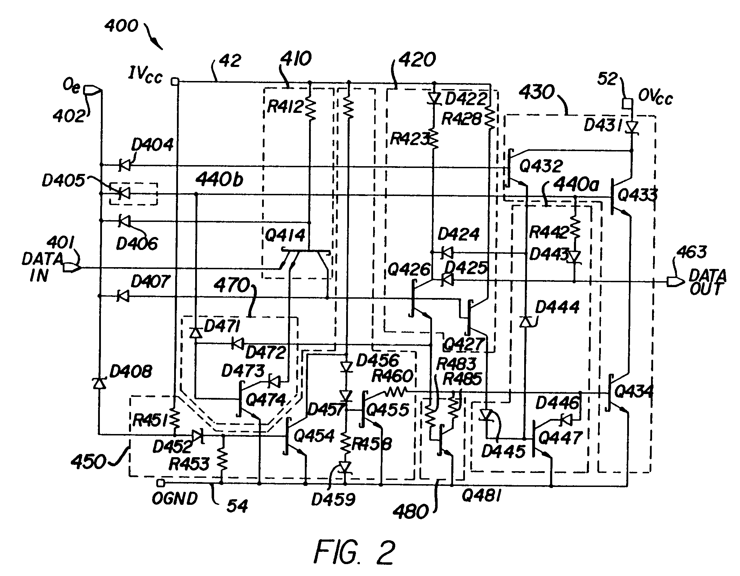

A schematic diagram of a latch 300 and an output buffer 400, modified to reduce the effect of power rail perturbations, is set forth in Figures 1 and 2 respectively. Power is provided to latch 300 and some circuits in buffer 400 through isolated power rails 42 ($IV_{cc}$) and 44 (IGND). Power is provided to other circuits in buffer 400 through isolated power rails 52 ($OV_{cc}$) and 54 (OGND).

Latch 300 is transparent to data applied to terminal 302 (DATA IN) when latch enable input signal $L_e$ is in a HIGH state. Latch enable signal $L_e$ is applied at terminal 340, which is connected to the base of Schottky transistor Q311 in switch 310 through Schottky diodes D341 and D342, and to the base of Schottky transistor Q324 in switch 30 through Schottky diode D343. Transistor Q324 is ON due to base drive through resistor 344, forward biasing the $BE_2$ junction of Schottky transistor Q321 in switch 320 through the BC (shorted collector) diode D329. The potential at the base of transistor Q321 goes to about $2V_{be}+V_{ce}+V_{sd}$ above ground, which is not sufficient to turn transistor Q312 ON. Hence, so long as $L_e$ is HIGH, Q312 is unaffected by the level at DATA IN and remains OFF.

When DATA IN goes low, Schottky diode D313 conducts and pulls down the base of Schottky transistor Q311 in switch 310, turning it OFF. Schottky transistor Q312 is OFF. Schottky transistor Q322 in switch 320 turns OFF and allows Schottky transistor Q323 in switch 320 to turn ON through resistor R325 and Schottky diode D328. As a result, (a) the output terminal 303 is brought LOW; and (b) the $BE_1$ junction of multiple emitter Schottky transistor Q321 is forward biased through resistor R326 and Schottky diode D327, whereby the potential at the base of transistor Q321 becomes $V_{be}+V_{ce}+2V_{sd}$ above ground. Transistor Q312 remains OFF.

When DATA IN goes HIGH, transistor Q311 in switch 310 conducts and turns transistor Q322 in switch 320 ON. As a result, transistor Q323 in switch 320 turns OFF, whereby output terminal 303 is brought up to $3V_d$ through resistor R330, pn diodes D331 and D332, and BC (shorted collector) diode D333.

Data is latched by applying a LOW to $L_e$ terminal 340. The base of transistor Q311 is limited to $2V_{sd}+V_{ce}$ by Schottky diodes 341 and 342 and the $V_{ce}$ of the latch enable buffer (not shown) to ensure that transistor Q311 is held OFF. At the same time, the base of transistor Q324 in switch 320 is brought LOW through diode D343, and transistor Q324 turns OFF. As a result, the state of transistor Q323 prior to the HL transition of $L_e$ controls the state of transistor Q312 in switch 310, which in turn maintains the state of transistor Q323. Assuming Q323 ON (logical LOW at DATA OUT), the potential at the base of Q321 is $V_{be}+2V_{sd}+V_{ce}$, which is not sufficient to turn ON transistors Q312 and Q322. Transistor Q323 remains ON. Assuming Q323 OFF (logical HIGH at DATA OUT), the potential at the base of Q321 rises from $V_{be}+2V_{sd}+V_{ce}$ to $2V_{be}+2V_{sd}$ as $L_e$ goes LOW,

which is sufficient to keep transistors Q312 and Q322 ON. Transistor Q323 remains OFF.

As will be appreciated, latch 300 is sensitive to power rail perturbations. Erroneous operation of the latch 300 absent the power rail isolation feature occurs, for example, when the latch 300 attempts to latch a LOW while the transceiver is recovering from negative ground bounce exceeding $2V_{be}+V_{sd}(D328)-V_{sd}(D313)$ (less than about 1.5V). In this event, transistors Q311 and Q322 turn ON, and switch 320 latches a HIGH. Isolating the internal $V_{cc}$ rail 42 and ground rail 44 from the internal output power rails 52 and 54 (Figure 12B) does not allow output ground bounce of sufficient magnitude to couple into internal IGND rail 44, thereby avoiding erroneous operation due to power rail perturbations.

An improved Schottky clamped TTL output buffer 400 according to the present invention is shown in Figure 2. The circuit stages in the buffer 400 preferably include the input stage 410, a phase splitter stage 420, an output stage 430, a squaring network 480, an AC Miller killer circuit 440 (including sections 440a and 440b), and a DC Miller killer 450. A dynamic ground reference changer 470 may be provided to further reduce the effect of ground bounce; otherwise, the second emitter of transistor Q414 is omitted. Rail 42 is the isolated internal rail $IV_{cc}$ (see Figure 12A), rail 52 is the internal output $OV_{cc}$ rail, and rail 54 is the internal output ground OGND rail.

With $O_e$ HIGH at terminal 402, the operation of the output buffer 400 is as follows. The input stage 410 includes multiple emitter Schottky transistor Q414, the first emitter of which is connected to DATA IN through terminal 401. When DATA IN is LOW, transistor Q414 is forward biased through resistor R412 and pulls its collector LOW. The LOW is applied to the common bases of Schottky transistors Q426 and Q427 in phase splitter 420. Transistors Q426 and Q427 do not cut in; as a result, the Darlington pair of Schottky transistor Q432 and transistor Q433 in the output stage 430 conducts through Schottky diode D431 and raises output terminal 403 HIGH. Note that the buffer 400 is inverting. Pulldown transistor Q434 is OFF at this time.

When DATA IN goes high, transistor Q414 turns OFF and its BC junction becomes forward biased, which in turn forward biases transistors Q426 and Q427. Transistor Q427 pulls down the base of transistor Q432 in the Darlington pair, turning it and transistor Q433 OFF. About the same time, Transistor Q434 also becomes forward biased, its base flow obtained through resistor R428 and transistor Q427, resistor R423 and transistor Q426, and resistor R412 and the Schottky clamp of transistor Q414. Transistor Q434 pulls down output terminal 403, providing a LOW.

Diodes D424 and D425 are speed up diodes to discharge capacitances. When transistor Q426 turns ON and its collector voltage falls, diode D424 provides a discharge path for internal capacitance at the base of transistor Q433. Diode D425 provides a discharge path for load capacitance at terminal 403 through transistor Q426 to increase the base current of transistor Q434 and improve its current sinking capability during the HIGH-to-LOW output voltage transition.

Squaring network 480 includes Schottky transistor Q481 and resistors R483 and R485, connected between the base of transistor Q434 and internal output ground rail 54.

The output buffer 400 is tristated by application of a LOW to $O_e$ terminal 402. In this event, the base of transistor Q414 in the input stage 410 is pulled down through Schottky diode 406, the common base of transistors Q426 and Q427 in the phase splitter 420 is pulled down through Schottky diode D407, and the base of transistor Q432 in the output stage 430 is pulled down through Schottky diode D404. A high impedance is thus presented at the output terminal 403.

The dynamic ground reference changer 470 functions to improve the noise margin at the interface of the latch 300 and buffer 400, which otherwise would be degraded by isolation of the respective internal power rails 42 and 44 from internal output power rails 52 and 54.

In the absence of circuit 470, the LH transition on output terminal 403 will experience noise in the form of a flat spot, glitch, or oscillation, as follows. Assuming that transistor Q434 in the output stage 430 is loaded with current from a following device (not shown), a HL transition at the latch input terminal 302 will cause transistor Q323 in latch switch 320 to conduct. After some propagation delay time, transistor Q434 will turn OFF, causing a large negative di/dt along the output ground rail 54. Note that transistors Q426 and Q427 in the phase splitter 420 and transistor Q434 in the output stage 430 are held OFF by the path through Q414 in input stage 410, and Q323 and diode D328 in switch 320. When

$$V_{sat}(Q323) + V_{sd}(D328) + V_{sat}(Q414) >$$
$$V_{be}(Q426) + V_{be}(Q434) + V_{groundbounce} \quad (2)$$

then the LH transition on the collector of transistor Q434 will have a flat spot, glitch, or oscillation.

The dynamic ground reference changer 470 functions to reference a second emitter of Q414 to output internal ground rail 54 instead of the isolated internal ground rail 44 during ground bounce. During an output LH transition at terminal 403, the cathode of diode D471 (shown enhanced), which is connected to the emitter of transistor Q432 in the output stage 430, begins to rise. Diode D471 is reversed biased, and couples sufficient current through its junction capacitance to the base of Schottky transistor Q474 (shown enhanced) to saturate it. Once saturated, transistor Q474 holds LOW the second emitter of transistor Q414, whereby the common base of transistors Q426 and Q427 in phase splitter 420 are referenced to output ground. During an output LH transition on other terminals of the octal registered transceiver when terminal 403 is high, the potential at the cathode of diode D471 falls slightly due to the di/dt of the charging current flowing in the $V_{cc}$ power rails. Nonetheless, an occurrence of ground bounce will cause the anode of diode D471 to fall faster the falling potential at its cathode. Diode D471 is reversed biased, and again couples sufficient current to the base of transistor Q474 to saturate it. A suitable value for the junction capacitance of diode D471 is about 300 fF, bearing in mind that the actual value depends on the values selected by the designer for the other circuit components. Other elements in circuit 470 include diodes D472 and D473. Diode D472 is connected between the base of transistor Q474 and the base of pulldown transistor Q434 to avoid completely discharging the base of transistor Q474 when a falling transition is present at the N-side of diode D471. Diode D473 is connected between the collector of transistor Q474 and the second emitter of transistor Q414, for providing the same LOW level as provided by the latch 300.

The AC Miller killer circuit 440 functions to improve the output rise time and minimize power consumption during repetitive switching. In principle, the AC Miller killer circuit 440 provides a momentary low impedance at the base of transistor Q434 during an output LH transition, thereby absorbing displacement current flowing through the collector-base capacitance of transistor Q434. In operation, rising voltage at the emitter of transistor Q432 causes displacement current to flow through BC diode D444, momentarily turning on transistor Q447. Transistor Q447 pulls down the base of transistor Q434 of the output stage 430 to absorb the displacement current flowing through the CB capacitance of Q434. When Q434 turns ON, diode D444 is discharged by D424. Diode D446 optimizes the pulldown level of transistor 447.

Unfortunately, a standard AC Miller killer circuit aggravates power rail perturbation during an LZ transition at high speed and with heavy loads at the output. In a standard AC Miller killer circuit arrangement, the cathode of D444 would reference to the output (terminal 403) through only a resistor (not shown). While the output is relatively stable during an LZ transition, a power rail perturbation such as, for example, ground bounce, causes internal ground to fall, thereby increasing the voltage across diode D444. Diode D444 discharges into transistor Q447, turning it ON and draining off some base charge from Q434. As a result, the discharge rate of Q434 is hastened, aggravating the ground bounce.

This problem is solved in AC Miller killer circuit 440 by removing the discharge effect. Schottky diode D405 (shown enhanced) functions to prevent circuit 440 from responding during an LZ transition by pulling the cathode of diode D444 to a level $V_{sd}$ above $O_e$, thereby preventing the development of a positive dv/dt across diode D444 during ground bounce. Schottky diode D443 (shown enhanced) is added to the circuit referencing D444 to the output 403, so that $O_e$ terminal 402 will not sink current through resistor 442 and diode D405 when output terminal 403 is tristated and the bus is brought HIGH.

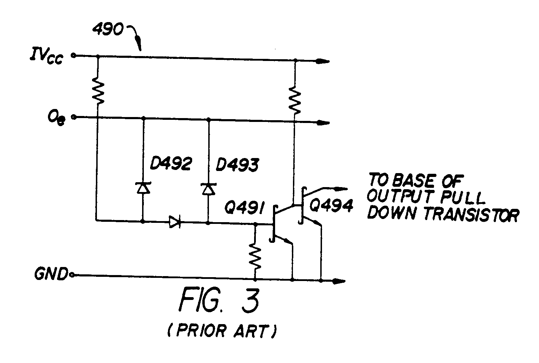

The DC Miller killer 450 provides the output stage 430 with immunity from noise on the bus when output buffer 400 is in tristate. A large positive voltage spike on the bus could couple charge across the Miller capacitance of transistor Q434 and erroneously turn it ON. In a standard DC Miller killer circuit (Figure 3), Schottky transistor Q491 is held OFF by a LOW Oe through Schottky diode D492. Schottky transistor Q494 is ON, holding down the base of the output pulldown transistor and providing a low impedance path to ground for any charged coupled through its BC (Miller) capacitance.

Unfortunately, a standard DC Miller killer circuit also aggravates power rail perturbation during an LZ transition at high speed and with heavy loads at the output. As $O_e$ is brought LOW, Q494 rapidly turns ON and rapidly discharges the base of the output pulldown transistor, thereby aggravating ground bounce.

This problem is solved in DC Miller killer circuit 450 by delaying its turn on and by limiting the discharge rate of the output pulldown transistor through circuit 450. The turn on of circuit 450 is delayed by the addition of pn diodes D456 and D457 (shown enhanced) between the collector of transistor Q454 and the base of transistor Q455, which increase the voltage swing required to turn on transistor Q455 and lowers the amount of base drive available to it. As diodes D456 and D457 block discharge of stored charge in the base of Q455, a discharge path is provided from the base of Q455 to ground through resistor R458 and diode D459 (shown enhanced). The discharge rate of the output pulldown transistor Q434 through circuit 450 is limited by the addition of resistor R460 (shown enhanced), having a low value of for example 500 ohms, in the collector circuit of transistor Q455. The value of resistor R460 should be limited to avoid negating the purpose of the DC Miller killer circuit 450.

## Claims

1. An integrated circuit output buffer having an input circuit, and output circuit having an output pulldown transistor (Q434), and a DC Miller killer circuit, said DC Miller killer circuit comprising:

a first transistor (Q455) for discharging charge coupled through the Miller capacitance of said output pulldown transistor (Q434);

a first resistor (R485) connected between the collector of said first transistor (Q455) and the base of said output pulldown transistor (Q434), the value of said first resistor (R485) being selected to limit the discharge rate of said output pulldown transistor (Q434);

a second transistor (Q454) for switching said first transistor (Q455) in response to an output enable signal;

at least one diode (D456, D457) connected between the collector of said second transistor (Q454) and the base of said first transistor (Q455),

the number of diodes being selected to delay the turn-on of said first transistor (Q455); and

a discharge path including a resistor (R458) and a diode (D459) connected in series between the base of said first transistor (Q455) and ground, for discharging stored charge from the base of said first transistor (Q455).

2. An output buffer as in claim 1, wherein a $V_{cc}$ power rail coupled to said input circuit and said DC Miller killer circuit is isolated from a $V_{cc}$ power rail coupled to said output circuit.

## Patentansprüche

1. Eine integrierte Ausgangspufferschaltung mit einem Eingangsschaltkreis und einem Ausgangsschaltkreis mit einem Ausgangsniederziehtransistor (Q434) und mit einem Gleichspannungs-Miller-Killer-Schaltkreis, welcher Gleichspannungs-Miller-Killer-Schaltkreis umfaßt:

einen ersten Transistor (Q455) für die Entladung der durch die Miller-Kapazität des Ausgangsniederziehtransistors (Q434) gekoppelten Ladung;

einen ersten Widerstand (R485), angeschlossen zwischen dem Kollektor des ersten Transistors (Q455) und der Basis des Ausgangsniederziehtransistors (Q434), wobei der Wert des ersten Widerstandes (R485) ausgewählt ist zum Begrenzen der Entladungsrate des Ausgangsniederziehtransistors (Q434);

einen zweiten Transistor (Q454) für das Schalten des ersten Transistors (Q455) in Reaktion auf ein Ausgangsentsperrsignal;

mindestens eine Diode (D456, D457), angeschlossen zwischen dem Kollektor des zweiten Transistors (Q454) und der Basis des ersten Transistors (Q455),

wobei die Anzahl von Dioden ausgewählt ist zum Verzögern des Einschaltens des ersten Transistors (Q455); und einen

Entladepfad mit einem Widerstand (R458) und einer Diode (D459), in Serie geschaltet zwischen die Basis des ersten Transistors (Q455) und Masse, für das Entladen gespeicherter Ladung von der Basis des ersten Transistors (Q455).

2. Ein Ausgangspuffer nach Anspruch 1, bei dem eine $V_{CC}$-Leistungsversorgungsschiene, angekoppelt an den Eingangsschaltkreis und den Gleichspannungs-Miller-Killer-Schaltkreis, isoliert ist von einer $V_{CC}$-Leistungsversorgungsschiene, die an den Ausgangsschaltkreis angekoppelt ist.

## Revendications

1. Tampon de sortie pour circuit intégré ayant un circuit d'entrée et un circuit de sortie ayant un transistor de sortie d'excursion basse (Q434) et un circuit d'annulation de l'effet Miller à courant continu, ledit circuit d'annulation de l'effet Miller à courant continu comprenant :

un premier transistor (Q455) pour décharger une charge reliée par l'intermédiaire de la capacité Miller dudit transistor de sortie d'excursion basse (Q434);

une première résistance (R485) connectée entre le collecteur dudit premier transistor (Q455) et la base dudit transistor de sortie d'excursion basse (Q434), la valeur de ladite première résistance (R485) étant choisie pour limiter la vitesse de décharge dudit transistor de sortie d'excursion basse (Q434);

un deuxième transistor (Q454) pour commuter ledit premier transistor (Q455) en réponse à un signal d'autorisation de sortie;

au moins une diode (D456, D457) connectée entre le collecteur dudit deuxième transistor (Q454) et la base dudit premier transistor (Q455),

le nombre de diodes étant sélectionné pour retarder l'enclenchement dudit premier transistor (Q455); et

un trajet de décharge comprenant une résistance (R458) et une diode (D459)connectée en série entre la base dudit premier transistor (Q455) et la masse, pour décharger la charge stockée à partir de la base dudit premier transistor (Q455).

2. Tampon de sortie selon la revendication 1 dans lequel un rail de puissance $V_{CC}$ relié audit circuit d'entrée et audit circuit d'annulation de l'effet Miller à courant continu est isolé d'un rail de puissance $V_{CC}$ relié audit circuit de sortie.

FIG. 1

FIG. 2

FIG. 3
(PRIOR ART)